(19) Europäisches Patentamt

European Patent Office

Office européen des brevets

(11) **EP 4 686 953 A1**

(12) **EUROPEAN PATENT APPLICATION**

(43) Date of publication:
04.02.2026  Bulletin 2026/06

(21) Application number: 25191938.7

(22) Date of filing: 25.07.2025

(51) International Patent Classification (IPC):
**G01R 31/327** (2006.01)

(52) Cooperative Patent Classification (CPC):
**G01R 31/3272; G01R 31/3271**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **29.07.2024  CN 202411029281**

(71) Applicant: **ABB SCHWEIZ AG**
**5400 Baden (CH)**

(72) Inventors:
• **HUANG, Ming**
**Xiamen, 361006 (CN)**

• **WU, Peiyou**
**Xiamen, 361000 (CN)**
• **FU, Zhihua**
**Xiamen, 361000 (CN)**
• **LV, Fuzhi**
**Xiamen, 361000 (CN)**
• **JING, Xiaofeng**
**Xiamen, 361000 (CN)**

(74) Representative: **Zimmermann & Partner**
**Patentanwälte mbB**
**P.O. Box 330 920**
**80069 München (DE)**

(54) **SWITCH CABINET TEST TROLLEY, AUTOMATIC TESTING SYSTEM AND MEDIUM-VOLTAGE POWER DISTRIBUTION CABINET TESTING ASSEMBLY**

(57)     The present invention relates to a test trolley for a switch cabinet, an automatic testing system comprising the test trolley, and a testing assembly for a medium-voltage power distribution cabinet. The test trolley comprises: a power supply device, for supplying a test electrical signal to the switch cabinet when the switch cabinet enters a testing procedure; a switching device, comprising multiple switches, each switch being used to connect the power supply device to a corresponding one of the multiple test points or to a neutral point; a control unit, configured to selectively control the on/off switching of the switches in the switching device; and a measurement device, configured to selectively measure a current value and/or a voltage value on at least one of the multiple phase power supply circuits under the control of the control unit, and feed a measurement result back to the control unit, wherein the control unit determines electrical performance of the switch cabinet on the basis of the measurement result provided by the measurement device.

Fig. 6

EP 4 686 953 A1

**Description**

Technical Field

The present invention relates to the field of switch cabinet testing, in particular to a test trolley for a switch cabinet, an automatic testing system comprising the test trolley, and a testing assembly for a medium-voltage power distribution cabinet.

Background Art

Medium-voltage switch cabinets play a crucial role in modern power systems, so their performance and reliability have a direct impact on the stability and safety of the power system. To ensure safe operation of a switch cabinet, it must undergo handover testing according to a given standard before entering use, and must also undergo periodic maintenance after entering use, so that any safety risks in the switch cabinet can be found promptly.

In a conventional medium-voltage switch cabinet testing procedure, a portable testing device for example is typically used to perform electrical performance testing of the switch cabinet. Existing testing devices generally require manual operation, which not only increases the intensity of labour performed by on-site service personnel, but also results in low testing efficiency and a high likelihood of errors in operation, due to operational complexity and reliance on operator skill. For example, when performing inspection and measurement of primary through-flow in a current transformer, in order to apply a test current to two ends of a cable and a bus, a series of intricate operations must be performed in advance, including circuit breaker opening and cranking-out, grounding switch closing, cable chamber door removal and installation, etc. These operations require time and effort, and might also cause damage to the body of the switch cabinet due to frequent disassembly and assembly steps, thereby impacting the performance and service life of equipment.

In addition, when a conventional testing device is used to subject a switch cabinet to a testing procedure, it is necessary to switch between different testing tools frequently; this not only increases the workload of on-site service personnel, but also increases the time needed for coordination and link-up during testing. Differences in testing device type and operating method may have an impact on the accuracy of test data, and this makes it difficult to analyse historical data and establish trends. Furthermore, when on-site service personnel are performing testing, most operations are performed in front of the cabinet, and this presents a safety risk. For example, when testing a circuit breaker, it is necessary to remove the circuit breaker panel, and perform multiple steps such as insulation resistance testing, conduction resistance testing, mechanical characteristic testing and AC voltage tolerance testing. These steps are not only repetitive and intricate, but also increase operational complexity and the risk of errors, due to frequent switching between testing tools. Thus, there is still considerable room for improvement in the design and manner of operation of testing devices for medium-voltage switch cabinets.

Summary of the Invention

The present invention is intended to solve the abovementioned shortcomings in existing switch cabinet testing systems, and proposes a novel switch cabinet test trolley which, through automation and the introduction of intelligent features, increases switch cabinet testing efficiency, reduces the intensity of labour for testing staff, and increases testing procedure safety and accuracy.

A first aspect of the present invention proposes a test trolley for a switch cabinet, wherein multiple test points and multiple phase power supply circuits are provided in the switch cabinet, each of the multiple phase power supply circuits having one end connected to a corresponding one of the multiple test points, and another end connected to a neutral point, and when the switch cabinet enters a testing procedure, the test trolley is electrically connected to the multiple test points of the switch cabinet, wherein the test trolley comprises:

a power supply device, for supplying a test electrical signal to the switch cabinet when the switch cabinet enters a testing procedure;

a switching device, comprising multiple switches, each switch being used to connect the power supply device to a corresponding one of the multiple test points or to the neutral point;

a control unit, configured to selectively control the on/off switching of the switches in the switching device, so as to supply AC or DC to at least one of the multiple phase power supply circuits by means of the power supply device; and

a measurement device, configured to selectively measure a current value and/or a voltage value on at least one of the multiple phase power supply circuits under the control of the control unit, and feed a measurement result back to the control unit,

wherein the control unit is further configured to determine electrical performance of the switch cabinet on the basis of the measurement result provided by the measurement device.

According to an optional embodiment, the power supply device comprises a DC power supply device, for supplying constant DC to at least one of the multiple phase power supply circuits when the switch cabinet enters a testing procedure;

the switching device comprises a first switching assembly consisting of multiple switches, each switch in the first switching assembly having a first end connected to a positive pole or a negative pole of the DC power supply device, and a second end connected to a corresponding one of the multiple test points or to the neutral point,

wherein the control unit is configured to selectively close two corresponding switches in the first switching assembly, so that DC outputted by the DC power supply device flows through at least one of the multiple phase power supply circuits,

the measurement device comprises a DC measurement circuit, and the control unit is further configured to control the DC measurement circuit to selectively measure voltage values at multiple target sampling points on a current circulation path located between the DC power supply device and the switch cabinet, so as to determine electrical performance of the switch cabinet on the basis of the voltage values at the multiple target sampling points.

According to an optional embodiment, the DC measurement circuit comprises a current divider, a second switching assembly and a signal acquisition board, the current divider being connected in series between the positive pole or negative pole of the DC power supply device and a first end of the first switching assembly, the second switching assembly consisting of multiple contactors, each contactor having one end connected to a corresponding one of the multiple test points or to the negative pole of the DC power supply device, and another end connected to the signal acquisition board, wherein the control unit is further configured to:

control the DC measurement circuit to acquire a voltage drop across the current divider, so as to calculate an output current of the DC power supply device on the basis of the voltage drop;

selectively close two corresponding contactors in the second switching assembly, so as to control the signal acquisition board to acquire a voltage difference between a corresponding one of the multiple test points and the negative pole of the DC power supply device, or acquire a voltage difference between two corresponding test points of the multiple test points; and

calculate a circuit resistance of each phase power supply circuit in the switch cabinet on the basis of the voltage difference acquired by the signal acquisition board and the output current of the DC power supply device.

According to an optional embodiment, the first switching assembly comprises:

multiple first switches, each first switch being arranged between the positive pole of the DC power supply device and one corresponding test point in the switch cabinet;

multiple second switches, each second switch being arranged between one corresponding test point in the switch cabinet and the negative pole of the DC power supply device; and

a third switch, arranged between the negative pole of the DC power supply device and the neutral point of the switch cabinet,

wherein the control unit is further configured to:

selectively close the third switch and at least one of the multiple first switches, so that DC supplied by the DC power supply device flows through at least one phase power supply circuit, connected in parallel with each other, of the multiple phase power supply circuits; or

selectively close a corresponding one of the multiple first switches and a corresponding one of the multiple second switches, so that DC supplied by the DC power supply device flows through two phase power supply circuits, connected in series with each other, of the multiple phase power supply circuits.

According to an optional embodiment, the signal acquisition board comprises two voltage sampling ports, and the second switching assembly comprises:

multiple first contactors, each first contactor being arranged between one corresponding test point in the switch cabinet and a first voltage sampling port of the signal acquisition board;

multiple second contactors, each second contactor being arranged between one corresponding test point in the switch cabinet and a second voltage sampling port of the signal acquisition board; and

a third contactor, arranged between the first voltage sampling port of the signal acquisition board and the negative pole of the DC power supply device,

wherein the control unit is configured to determine the on/off switching of each contactor in the second switching assembly on the basis of a switch state of each switch in the first switching assembly, in order to acquire a voltage difference between two respectively connected test points of the multiple test points, or a voltage difference between at least one connected test point and the negative pole of the DC power supply device, by means of the signal acquisition board.

According to an optional embodiment, the control unit is further configured to:

close the third switch, and open the multiple second switches;

sequentially close each of the multiple first switches to connect the corresponding test point, and determine multiple first resistance values between the connected test point and the negative pole of the DC power supply device by means of the DC measurement circuit;

close any two of the multiple first switches so that any two of the multiple phase power supply circuits form a parallel-connected circuit, and determine a second resistance value between the connected test point and the negative pole of the DC power supply device by means of the DC measurement circuit; and

based on the multiple first resistance values and the second resistance value, calculate circuit resistances of the phase power supply circuits in the switch cabinet.

According to an optional embodiment, the control unit is further configured to close the third contactor and a corresponding one of the multiple second contactors when determining the multiple first resistance values, and close the third contactor and two corresponding second contactors of the multiple second contactors when determining the second resistance value.

According to an optional embodiment, the control unit is further configured to:

open the third switch;

close a corresponding one of the multiple first switches and a corresponding one of the multiple second switches, so that any two of the multiple phase power supply circuits form multiple different series-connected circuits, and respectively determine third resistance values of the multiple different series-connected circuits by means of the DC measurement circuit; and

based on the third resistance values of the multiple different series-connected circuits, calculate circuit resistances of the phase power supply circuits in the switch cabinet.

According to an optional embodiment, the control unit is further configured to close a corresponding one of the multiple first contactors and a corresponding one of the multiple second contactors when determining the third resistance values of the multiple different series-connected circuits.

According to an optional embodiment, the power supply device further comprises an AC power supply device, configured to supply at least one phase of AC to the switch cabinet when the switch cabinet enters a testing procedure.

According to an optional embodiment, the AC power supply device comprises:

multiple power supply conversion modules, each power supply conversion module being configured to receive AC from an external power grid and subject same to a voltage and/or current adjustment operation, so as to output a required test current to a corresponding one of the multiple phase power supply circuits of the switch cabinet; and

a third switching assembly, comprising a fourth switch and multiple fifth switches, each fifth switch being used to connect a first output end of a corresponding one of the multiple power supply conversion modules to one corresponding test point in the switch cabinet, and the fourth switch being used to connect a second output end of the multiple power supply conversion modules to the neutral point of the switch cabinet,

wherein the control unit is further configured to selectively close the fourth switch and at least one of the multiple fifth switches, so as to supply at least one phase of AC to the switch cabinet.

According to an optional embodiment, the measurement device further comprises multiple Hall sensors, each Hall sensor being arranged on an output line of a corresponding one of the multiple power supply conversion modules, and used to measure a current value of AC outputted by the AC power supply device to the switch cabinet.

According to an optional embodiment, the control unit is further configured to subject the switch cabinet to performance testing on the basis of a measurement result of the multiple Hall sensors, the performance testing being selected from at least one of a group comprising overcurrent protection testing, zero sequence overcurrent protection testing, voltage protection testing, frequency protection testing, differential protection testing, current transformer data testing, temperature sensor data testing and zero sequence current testing.

A second aspect of the present invention further proposes an automatic testing system for a switch cabinet, the system comprising:

the test trolley described above;

a mechanical unlocking device, for releasing mechanical locking between a circuit breaker of the switch cabinet and a grounding switch; and

a main control device, configured to send a corresponding enable signal to the test trolley after mechanical locking of the switch cabinet has been released, so that the test trolley begins to subject the switch cabinet to a testing procedure.

A third aspect of the present invention further proposes a testing assembly for a medium-voltage power distribution cabinet, the medium-voltage power distribution cabinet comprising multiple switch cabinets, a ground bar, and a busbar formed of multiple phase buses, wherein multiple phase power supply circuits are provided in each switch cabinet, each of the multiple phase power supply circuits having one end connected via a corresponding circuit breaker to one corresponding phase bus in the busbar, and another end connected via a corresponding grounding switch to the ground bar, wherein the testing assembly further comprises the automatic testing system described above,
wherein the main control device is further configured, when subjecting a corresponding one of the multiple switch cabinets to a testing procedure, to cause the corresponding one switch cabinet to enter a test position and cause the test trolley to enter a working position, so as to form a test circuit between the switch cabinet and the test trolley, the control unit of the test trolley is further configured to send an instruction signal to the main control device upon completion of the testing procedure for the corresponding one switch cabinet, and the main control device is configured, upon receiving the instruction signal from the test trolley, to cause the corresponding one switch cabinet to exit the test position and cause the next switch cabinet to enter the test position, until the testing procedures for all of the switch cabinets are completed, wherein, in the test position, the grounding switch and the circuit breaker of each phase power supply circuit in the corresponding one switch cabinet are closed.

Compared with a conventional, manually operated switch cabinet test trolley, the test trolley of the present invention has many advantages. Firstly, as a result of integrating DC and AC power supply modules, the test trolley is able to provide various required power supplies for the switch cabinet, including constant DC and multi-phase AC. This integrated design reduces dependence on external power supplies, while also making testing more convenient and reliable. Secondly, the automated control unit of the test trolley can intelligently manage testing procedures of multiple switch cabinets, including on/off switching of switches, measurement of current and voltage, and data acquisition and analysis. This not only reduces the workload of on-site service personnel, but also reduces errors and risk caused by improper human operation. In addition, the test trolley of the present invention is also highly flexible and adaptable, being able to adapt to testing requirements and system configurations of different switch cabinets, while the modular design thereof allows rapid switching between different test functions, thus reducing the time taken to prepare and switch between different tools during testing. Finally, the intelligent and automated characteristics of the test trolley of the present invention enable it to conveniently perform storage and analysis of historical data and predict trends, thus providing effective data support for switch cabinet maintenance and management.

Brief Description of the Drawings

Through the drawings incorporated herein and the specific embodiments which are later used together with the drawings to explain certain principles of the present invention, other features and advantages of the method of the present invention will become clear or be illustrated in more specific terms.

Fig. 1 shows a schematic diagram of a test trolley arranged in a conventional medium-voltage power distribution cabinet.

Fig. 2 shows a diagram of the internal structure of a test trolley for a switch cabinet according to an exemplary embodiment of the present invention.

Fig. 3 shows a schematic circuit diagram of the test trolley according to the present invention being used to connect the A phase circuit of the switch cabinet in the single-phase circuit resistance testing scheme.

Fig. 4 shows a schematic circuit diagram of the test trolley according to the present invention being used to connect the circuits of the two phases A and B of the switch cabinet in the inter-phase circuit resistance testing scheme.

Fig. 5 shows a structural diagram of an AC power supply device of a test trolley according to an exemplary embodiment of the present invention.

Fig. 6 shows a block diagram of a switch cabinet automatic testing system according to an exemplary embodiment of the present invention.

Fig. 7 shows a flow chart of operations of the switch cabinet automatic testing system in Fig. 6.

Fig. 8 shows a flow chart of operations for using an automatic testing system according to an exemplary embodiment of the present invention to subject all switch cabinets in a medium-voltage power distribution cabinet to a testing procedure.

Detailed Description of the Invention

A test trolley for a switch cabinet according to the present invention is described below through embodiments with reference to the drawings. In the following description, many specific details are expounded to give those skilled in the art a more comprehensive understanding of the present invention. It will be obvious to those skilled in the art, however, that the invention may be implemented without some of these specific details. Rather, the use of any combination of the features and key elements described below may be contemplated for implementing the invention, whether or not they relate to different embodiments. Thus, the various aspects, features, embodiments and advantages below merely serve an illustrative purpose, and should not be regarded as limitations or key elements of the claims.

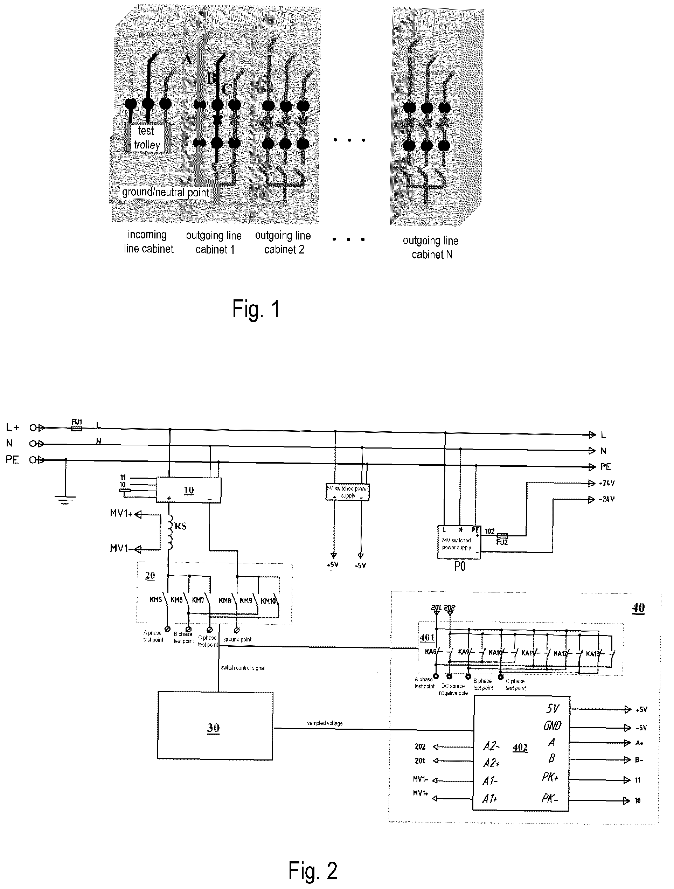

Fig. 1 shows a schematic diagram of a test trolley arranged in a conventional medium-voltage power distribution cabinet. The medium-voltage power distribution cabinet may comprise multiple switch cabinets 1 - N connected to each other in parallel, wherein a switch cabinet arranged at an inlet of the medium-voltage power distribution cabinet is an incoming line cabinet, which receives electrical energy from a power grid or a generator (the test trolley introduced below may for example be arranged in the line entry cabinet), and switch cabinets connected to various loads or sub-systems are outgoing line cabinets. In the case of a three-phase power distribution system which is most commonly encountered, each switch cabinet comprises three phase power supply circuits A, B, C connected to a load. For the purpose of subjecting the switch cabinet to performance testing, three corresponding test points are provided in each switch cabinet.

When it is necessary to begin a testing procedure for a particular switch cabinet, it is desired to electrically connect the three test points of the switch cabinet to testing equipment separately with the aid of static contacts. However, this process typically requires on-site service personnel to manually perform a series of intricate operations, including cabinet body disassembly, circuit breaker opening and cranking-out, grounding switch closing, cable chamber door removal and installation, manual operation of different testing tools, etc.; these operations require time and effort, and easily result in damage to the body of the switch cabinet due to differences in the skill level of different personnel. In addition, if only one testing tool is used, only one function can be tested; in order to test multiple functions, it is necessary to switch between different testing tools frequently and use equipment of different types. This further increases the complexity of the testing procedure and the risk of mistakes, thus affecting the uniformity and accuracy of test data, and this makes it difficult to monitor switch cabinet reliability and prevent faults.

For this reason, the present invention proposes a novel switch cabinet test trolley. Compared with conventional manually operated testing equipment, the test trolley of the present invention can realize fully automated operations, greatly reducing the workload of on-site service personnel. In particular, the test trolley employs a standardized automatic testing procedure; this not only results in a simpler and more normalized testing process, but also effectively avoids damage to the switch cabinet body due to improper human operation. In addition, the intelligent design of the test trolley enables testing tools to be switched automatically and different test functions to be performed, thereby reducing testing errors caused by frequent switching of testing tools, and increasing test data accuracy and the complexity of on-site coordination. More importantly, the test trolley reduces the time for which on-site service personnel are exposed to a dangerous environment, comprehensively reducing the work risk of service personnel, and increasing testing safety.

Fig. 2 shows a diagram of the internal structure of a test trolley for a switch cabinet according to an exemplary embodiment of the present invention. Firstly, it is likewise assumed that the test trolley is used to test a switch cabinet comprising three phase power supply circuits A, B, C. When the testing procedure is entered, a grounding switch in the switch cabinet is closed; one end of the three phase power supply circuits is connected to a neutral point; and another end, opposite the neutral point, of each phase power supply circuit is connected to a corresponding one of the three test points. As an example, the switch cabinet side may comprise static contacts for testing, and the test trolley side may comprise moving contacts; during testing, the static contacts of the three phase power supply circuits in the switch cabinet can be electrically connected to the moving contacts in the test trolley by means of corresponding contact arms. However, it will be understood that the manner in which the switch cabinet is connected to the test trolley is not limited to contact arm connection; for example, leads could also be used to electrically connect the switch cabinet to external testing equipment.

As an example, the test trolley can supply DC to the switch cabinet, and can test the electrical performance of the switch cabinet, for example the circuit resistance and insulation performance of the switch cabinet, on the basis of this DC. The DC power supply function of the switch cabinet test trolley, and the switch cabinet testing principles, are presented in detail below with reference to Fig. 2.

The test trolley may comprise a DC power supply module 10; when the switch cabinet enters the testing procedure, the DC power supply module 10 can supply constant DC to one or more phase circuits of the switch cabinet, as required. For example, when it is necessary to subject the switch cabinet to insulation resistance testing or ground resistance testing, the DC power supply module can ensure that direct current meeting the test standard requirements is supplied. The DC power supply module 10 may be designed as a constant current source, which may adopt an autonomous, independent power supply form, and may also receive mains electricity (also referred to as "mains frequency AC") from an external power grid and convert this to constant DC for output. The symbols "L+", "N" and "PE" in Fig. 2 respectively represent the live wire, neutral wire and protective earth wire of conventional mains electricity.

In order to input DC to a target phase of the switch cabinet as required, the test trolley may also comprise a first switching assembly 20, a control unit 30 and a DC measurement circuit 40. The first switching assembly consists of multiple switches; in the example of Fig. 2, these include KM5, KM6, KM7, KM8, KM9 and KM10. One end of these switches is connected to a positive pole or a negative pole of the DC power supply module, and another end is connected to a corresponding test point or the neutral point of the switch cabinet. This connection arrangement allows the first switching assembly to flexibly select a circulation path for direct current, to test the power supply circuits of different phases of the switch cabinet.

The control unit 30 is the brain of the test trolley, responsible for controlling the on/off switching of the various switches in the first switching assembly. Based on a preset testing procedure, the control unit automatically selects a corresponding switch to be closed or opened, thereby controlling the direct current to flow through a specific power supply circuit of the switch cabinet. For example, when performing a circuit resistance test of a particular phase, the control unit will close the switch connected to the test point of that phase, and open the other irrelevant switches.

The DC measurement circuit 40 comprises a current divider RS, a second switching assembly 401, a signal acquisition board 402 and other elements. The second switching assembly 401 likewise consists of multiple contactors KA8, KA9, KA10, KA11, KA12 and KA13. One end of these contactors is connected to multiple test points or the neutral point of the switch cabinet, and the other end is connected to the signal acquisition board 402. Each contactor can operate independently, and can also operate in linkage with the other contactors, to connect or disconnect a sampling path between a corresponding test point and the signal acquisition board 402. This design allows the test trolley to flexibly select measurement points, to acquire the required voltage data.

The control unit 30 not only controls the first switching assembly 20, but is also further configured to selectively control the various contactors in the second switching assembly 401. The control unit automatically chooses to close a specific contactor according to a test requirement, so as to form a specific voltage measurement circuit. For example, to measure a voltage difference between a test point A and the neutral point, the control unit will close the contactor connected to test point A and the contactor connected to the neutral point.

Based on the control of the on/off switching of these contactors by the control unit, the signal acquisition board 402 can immediately acquire a voltage difference between two sampling points, for example between two test points or between a particular test point and the neutral point. These voltage values are the basis for assessing the electrical performance of the switch cabinet. For example, during testing, based on the result of control of the on/off switching of the various contactors in the second switching assembly 401 by the control unit 30, the DC measurement circuit can acquire a voltage difference between two different test points, or measure a voltage difference between a particular test point and the neutral point, and can further calculate circuit resistances of the three phases of the switch cabinet on the basis of these two voltage differences and other information.

The other information referred to here may be values of current flowing through the three phase power supply circuits of the switch cabinet. These current values may be acquired by means of the current divider RS. The current divider RS is a known resistance device, which is connected in series between the positive pole or negative pole of the DC power supply module 10 and a first end of the first switching assembly 20. This configuration allows the current divider to generate a minute voltage drop when current passes, and this voltage drop can be precisely measured by the signal acquisition board 402 of the DC measurement circuit 40 (by means of sampling ports MV1+, MV1-). The control unit 30 can cooperate with the DC measurement circuit 40, and by analysing the voltage difference between two ends of the current divider, can calculate the actual current flowing through the current divider on the basis of Ohm's law.

Integrating the current divider RS in the DC measurement circuit 40 enables the test trolley to monitor and control an output current of the DC power supply module 10 in real time. This not only increases safety during testing but also ensures that test results are accurate, providing reliable current data for testing the electrical performance of the switch cabinet.

In the example of Fig. 2, a specific configuration of the first switching assembly 20 is shown, in order to control direct current to flow from the DC power supply module 10 to different test points of the switch cabinet, and control a current return path. Specifically, the first switching assembly 20 comprises KM5, KM6 and KM7; these switches connect the positive pole of the DC power supply module 10 to A, B and C phase test points of the switch cabinet respectively. This configuration allows direct current to flow from the DC power supply module 10 to corresponding test points, to test each phase of the switch cabinet independently. At the same time, switches KM8, KM9 and KM10 connect the negative pole of the DC power supply module 10 to B and C phase test points and the neutral point respectively, ensuring that current is able to flow smoothly back to the DC power supply module 10 from the test points or the neutral point.

In the example of Fig. 2, a specific configuration of the first switching assembly 401 is also shown, for realizing the functions of the signal acquisition board 402. The signal acquisition board is designed with two voltage sampling ports 201 and 202, for acquiring a voltage difference between two potentials. To achieve this objective, the second switching assembly 401 employs a synchronous double-pole double-throw (abbreviated SDPDT) switch design, comprising KA8, KA9, KA10, KA11, KA12 and KA13.

The SDPDT switch allows two poles or contact points to act synchronously, ensuring that two sampling paths can be closed or opened simultaneously. In Fig. 2, the design of contactors KA8, KA9 and KA10 allows them to simultaneously connect the A, B and C phase test points to voltage sampling port 201 of the signal acquisition board 402, and connect the neutral point to voltage sampling port 202. This design enables simultaneous acquisition of voltage differences between the neutral point and the test points.

At the same time, contactors KA11, KA12 and KA13 are designed to connect one of the A, B and C phase test points to voltage sampling port 201, and simultaneously connect another phase test point to voltage sampling port 202. This configuration allows measurement of voltage differences between different test points, thus imparting flexibility and diversity to the system.

However, it should be emphasized that the switch configuration shown in Fig. 2 is not the only embodiment of the present invention. The purpose of providing the first and second switching assemblies in the test trolley of the present invention is to provide a flexible current control and measurement mechanism, to adapt to different test demands and system configurations. Thus, besides the configuration described in Fig. 2, the test trolley of the present invention is likewise suitable for other ways of providing and connecting switches that are able to achieve the same connection objective, which should be included in the scope of protection of the present invention as long as they are able to achieve corresponding current control functions and voltage sampling functions.

For example, the second switching assembly 402 is not limited to using SDPDT switches, and not limited to the specific manner of connection shown in Fig. 2. Any other ways of providing and connecting switches that are able to achieve the objective of the present invention, such as single-pole single-throw (SPST), single-pole double-throw (SPDT) or other types of switches, should be regarded as equivalent embodiments of the present invention. In addition, different types of switches may be selected according to test requirements, such as electromagnetic relays, solid-state relays or other electronic switches, to adapt to different current and voltage levels. In addition, the manner in which the switches are connected to each other may also be adjusted according to actual circuit design requirements, realizing required current flow directions by series connection, parallel connection or other combination methods for example.

Based on the test trolley shown in Fig. 2, in particular the specific switch configuration within the test trolley, two different testing schemes can be used to

determine circuit resistances $R_a$, $R_b$, $R_c$ of three phase circuits of the switch cabinet. The two different testing schemes are referred to herein as a "single-phase circuit resistance testing scheme" and an "inter-phase circuit resistance testing scheme"; the specific operating processes and calculation principles of the two testing schemes are detailed below with reference to Fig. 2.

Single-phase circuit resistance testing scheme

Taking phase A as an example, when performing a circuit resistance test for phase A, the following operating steps may be performed:

- establishment of current flow direction: firstly, switches KM5 and KM8 are closed, so that current flows out of the positive pole of the DC power supply 10, flows to the A phase test point of the switch cabinet, passes through a contact and a main bus, reaches phase A of the switch cabinet, passes through an A phase circuit of the switch cabinet, then flows back via a ground bar to the negative pole of the DC power supply of the test trolley;

- current measurement: with this switch connection arrangement, current outputted by the DC power supply 10 only flows through the A phase circuit, in which case, the value of current passing through the A phase test point can be determined by means of the current divider RS;

- voltage measurement: contactor KA8 is then closed; contactor KA8 supplies voltage values of the A phase test point and the negative pole of the DC power supply unit 10 to the signal acquisition board 402, and the control unit 30 can thus determine an A phase voltage value;

- calculation of circuit resistance: based on the A phase voltage value and the current value measured in the above steps, the value of resistance $R_1$ over the entire current path can be calculated using Ohm's law.

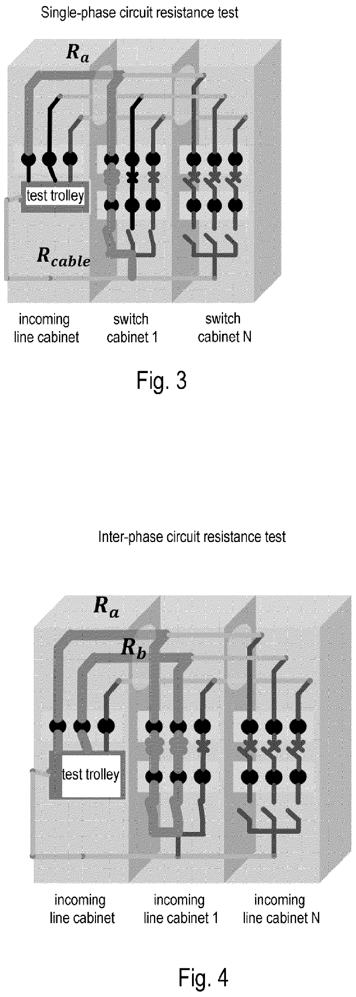

With KM5 and KM8 closed, current flows through the A phase circuit and a ground line - the ground line is a connecting cable between the neutral point of the switch cabinet and the negative pole of the DC power supply device 10. Therefore, the calculated resistance value $R_1$ is the sum of A phase circuit resistance $R_a$ and ground line resistance $R_{cable}$, i.e. $R_1 = R_a + R_{cable}$. Fig. 3 shows a schematic circuit diagram of the test trolley according to the present invention being used to connect the A phase circuit of the switch cabinet in the single-phase circuit resistance testing scheme.

By the same principle, when performing a circuit resistance test for phase B, KM6, KM8 and KA9 can be closed, and when performing a circuit resistance test for phase C, KM7, KM8 and KA10 can be closed; and using the same current measurement, voltage measurement and circuit resistance calculation steps as described above, resistance values $R_2$, $R_3$ over the current paths formed with these two switch connection arrangements can be determined, respectively being the sum of B phase circuit resistance $R_b$ and ground line resistance $R_{cable}$, i.e. $R_2 = R_b + R_{cable}$, and the sum of C phase circuit resistance $R_c$ and ground line resistance $R_{cable}$, i.e. $R_3 = R_c + R_{cable}$.

In order to further calculate the circuit resistances $R_a$, $R_b$, $R_c$ of each phase power supply circuit, it is necessary to set up an additional auxiliary equation; for this purpose, simultaneous connection of two phases of the three phase power supply circuits is considered, so that these two phases form a parallel-connected circuit. For example, KM5, KM8 and KA8, and also KM6, KM8 and KA9, are closed at the same time, in which case, the output current of the DC power supply device 10 flows through a parallel-connected path of phase A and phase B and also the ground line, and it is thus possible to obtain another resistance calculation formula for this current circulation path: $R_4 = R_a R_b/(R_a+R_b) + R_{cable}$.

All of the resistance calculation formulae obtained by the operating processes described above are brought together:

$$\begin{cases} R_1 = R_a + R_{cable} \\ R_2 = R_b + R_{cable} \\ R_3 = R_c + R_{cable} \\ R_4 = \frac{R_a R_b}{R_a+R_b} + R_{cable} \end{cases},$$

When $R_4{}^2 - 3R_1 R_4 - 3R_2 R_4 + 3R_1 R_2 \geq 0$, the following can be derived:

$$R_{cable} = \frac{2R_4 \pm \sqrt{4(R_4{}^2 - 3R_1 R_4 - 3R_2 R_4 + 3R_1 R_2)}}{6},$$

Further, the circuit resistances of the three phase power supply circuits can be derived:

$$R_a = R_1 - R_{cable}$$

$$R_b = R_2 - R_{cable}$$

$$R_c = R_3 - R_{cable}.$$

Inter-phase circuit resistance testing scheme

Taking phases A and B as an example, when performing a corresponding circuit resistance test, the following operating steps may be performed in sequence:

- establishment of current flow direction: firstly, switches KM5 and KM9 are closed, so that current flows out of the positive pole of the DC power supply 10, flows to the A phase test point of the switch cabinet, passes through a contact and the main bus, reaches phase A of the switch cabinet, passes through the A phase circuit of the switch cabinet, then transfers from phase A to phase B via the neutral point of a star connection (which may for example be a grounding switch position in the switch cabinet, or a ground bus position), then flows back through the main bus to another contact of the test trolley, and returns via KM9 to the negative pole of the DC power supply;

- current measurement: with this switch connection arrangement, current outputted by the DC power supply 10 flows through a series-connected circuit of phases A and B, in which case, the value of current passing through the A phase test point can be determined by means of the current divider RS;

- voltage measurement: contactor KA11 is then closed; contactor KA11 supplies voltage values of the A phase test point and the B phase test point to the signal acquisition board 402, and the control unit 30 can thus determine a value of voltage between phases A and B;

- calculation of circuit resistance: based on the current value and the value of voltage between phases A and B measured in the above steps, the value of resistance $R_{ab}$ over the entire current path can be calculated using Ohm's law.

As used herein, the term "star connection" means that in a multi-phase power supply network, the power supply circuits of at least two phases are connected at one end to a common reference point, and at the other end to a load or a power supply device, thereby forming a star-shaped topological structure. The reference point may be called a neutral point of the star connection, and this neutral point may be connected to a ground bus (for example, in the single-phase circuit resistance testing scheme), or not grounded (for example, in the inter-phase circuit resistance testing scheme).

Returning to the inter-phase circuit resistance testing scheme, if KM5 and KM9 are closed, current flows through the A phase circuit and the B phase circuit, so the calculated resistance value $R_{ab}$ is the sum of the A and B phase circuit resistances $R_a$ and $R_b$, i.e. $R_{ab} = R_a + R_b$. Fig. 4 shows a schematic circuit diagram of the test trolley according to the present invention being used to connect the circuits of the two phases A and B of the switch cabinet in the inter-phase circuit resistance testing scheme.

By the same principle, when performing a test of circuit resistance between phases B and C, KM6, KM10 and KA12 can be closed; when performing a test of circuit resistance between phases C and A, KM5, KM7 and KA13 can be closed; and using the same current measurement, voltage measurement and circuit resistance calculation steps as described above, resistance values $R_{bc}$, $R_{ca}$ over the current paths formed with these two switch connection arrangements can be determined, respectively being the sum of B phase circuit resistance $R_b$ and C phase circuit resistance $R_c$, i.e. $R_{bc} = R_b + R_c$, and the sum of C phase circuit resistance $R_c$ and A phase circuit resistance $R_a$, i.e. $R_{ca} = R_c + R_{cable}$.

All of the resistance calculation formulae obtained by the operating processes described above are brought together:

$$\begin{cases} R_{ab} = R_a + R_b \\ R_{bc} = R_b + R_c \\ R_{ca} = R_c + R_a \end{cases},$$

In addition, supposing that the power supply circuits of the three phases A, B and C are connected together in series, the value of resistance $R_{abc}$ of the current path formed is:

$$R_{abc} = (R_{ab} + R_{bc} + R_{bc})/2$$

Based on the above formula, the circuit resistances of the three phase power supply circuits can be further derived:

$$\begin{cases} R_c = R_{abc} - R_{ab} \\ R_a = R_{abc} - R_{bc}. \\ R_b = R_{abc} - R_{ca} \end{cases}$$

The operating processes and calculation principles of the two resistance testing schemes for "single-phase circuit resistance" and "inter-phase circuit resistance" have now been described and listed in detail; these two solutions show how the test trolley circuit structure of the present invention is used to precisely measure the circuit resistance for each phase of the switch cabinet. However, it should be clarified that the tested schemes listed are not the only embodiment of the present invention. In particular, the test trolley circuit structure of the present invention is designed to be highly flexible and adaptable, and is able to accommodate various resistance testing methods. In addition to the two schemes described above, the present invention is likewise suitable for all other resistance testing methods that can be implemented using the test trolley circuit structure of the present invention. These might include but are not limited to other measurements of single-phase or multi-phase circuit resistance, and more complex circuit configurations or test processes that might be involved; all such variants fall within the scope of protection of the present invention.

The description above has focussed on the DC power supply and circuit resistance testing functions of the test trolley of the present invention, which may also have an AC power supply function. That is to say, an AC power supply device may also be integrated in the test trolley, the AC power supply device being configured to supply at least one phase of AC to the switch cabinet when the switch cabinet enters a testing procedure.

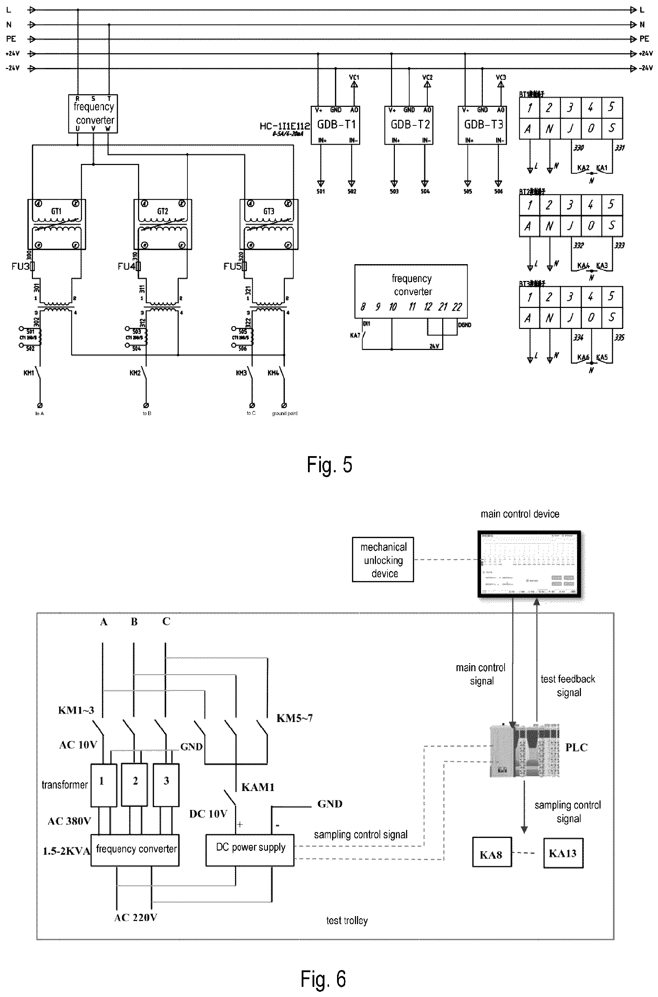

Fig. 5 shows a structural diagram of an AC power supply device of a test trolley according to an exemplary embodiment of the present invention. The AC power supply device may be used for switch cabinet temperature sensor power supply and current transformer through-flow testing, zero sequence current testing and other functions.

As shown in Fig. 5, the AC power supply device firstly comprises a frequency converter, the frequency converter being responsible for receiving mains frequency AC from an external power grid, and converting same to three-phase AC suitable for a test objective. In addition to the frequency converter, the function of converting single-phase power to three-phase power can also be realized by means of another device such as a phase shifter. This conversion process can adjust the output frequency and the number of phases according to test requirements. The AC power supply device further comprises three power supply conversion modules (which may also be called "transformers"), each module being designed to receive two phases of the three-phase AC outputted by the frequency converter. These power supply conversion modules subject the received AC to necessary voltage and/or current adjustment, to ensure that the test voltages that they output meet the power supply or test requirements for switch cabinet testing.

Although the AC power supply device is shown as comprising the frequency converter in Fig. 5, it could also be envisaged that the AC power supply device can receive three-phase AC directly from an external three-phase power supply; in this case, since there is no need to subject the inputted three-phase AC to frequency adjustment, the frequency converter can be omitted, in which case the externally inputted three-phase AC can be supplied directly to the transformers to undergo voltage and/or current adjustment. This structure is also an optional variant of the AC power supply device of the present invention.

In the design of the AC power supply device, multiple Hall sensors may also be added. These sensors are respectively arranged on output lines of corresponding power supply conversion modules, and used to measure in real time the values of AC current outputted via the power supply conversion modules to the switch cabinet. Based on these current values, switch cabinet performance testing related to AC power supply can be further performed; the performance testing may for example be selected from at least one of a group comprising overcurrent protection testing, zero sequence overcurrent protection testing, voltage protection testing, frequency protection testing, differential protection testing, current transformer data testing, temperature sensor data testing and zero sequence current testing.

As an example, the control unit can receive and process measurement signals from the Hall sensors, in order to analyse and calculate alternating current flowing through the switch cabinet, and then assess whether a zero sequence current thereof is within a normal range.

A third switching assembly consists of four switches: KM1, KM2, KM3 and KM4. KM1, KM2 and KM3 are responsible for connecting first output ends of the three power supply conversion modules, respectively, to corresponding test points in the switch cabinet; KM4 is responsible for connecting a second output end of all three power supply conversion modules to the neutral point in the switch cabinet.

These switches in the third switching assembly are likewise controlled by the control unit 30; such control operations allow the test trolley to flexibly supply at least one phase of AC to the switch cabinet, so as to perform the required testing procedure. For example, by closing KM4 and any one of KM1 and KM2 and KM3, single-phase AC can be supplied to the switch cabinet.

The control unit 30 can also control KM4 and any two of the three switches KM1, KM2 and KM3 to close, so as to supply two-phase AC to the switch cabinet. With this two-phase AC being supplied, the control unit 30 can, based on measurement results of the Hall sensors, send corresponding test data to a main control device, which automatically judges a zero sequence circuit protection function of a low-voltage box relay protection device, with reference to the test data and other collected general data.

In another example, the control unit 30 can control all of the switches KM1, KM2, KM3 and KM4 to close at the same time, in order to supply three-phase AC to the switch cabinet. With this three-phase AC being supplied, based on measurement results of the Hall sensors, a current transformer (abbreviated "CT") of the switch cabinet can be tested, and temperature sensor data can be tested. For example, based on measurement results of the Hall sensors, the control unit 30 can send test data to the main control device which, with reference to collected general data, judges whether data of the temperature sensor in the switch cabinet, and/or parameters such as transformation ratio and polarity of the current transformer, are normal. Specifically, the main control device (or the control unit 30) can compare measurement results of multiple Hall sensors with measurement results of the current transformer in the switch cabinet, in order to test whether characteristics (including parameters such as transformation ratio and polarity) of the current transformer are normal.

In addition, with this three-phase AC being supplied, the main control device (or the control unit 30) can also test whether components of the switch cabinet are normal, based on measurement results of the Hall sensors. For example, the "zero sequence current" in the switch cabinet represents the sum of three-phase current vectors in the three-phase AC system of the switch cabinet. Ideally, the zero sequence current should be zero. When a fault, such as three-phase load imbalance or grounding, occurs in the three phase circuits in the switch cabinet, the zero sequence current increases abnormally. Based on measurement results of the Hall sensors, the control unit 30 calculates zero sequence current components of the switch cabinet by comparing the amplitudes and phases of the currents of each phase. If the zero sequence current exceeds a preset safety threshold, this indicates that there might be an asymmetric load or another systemic fault in the switch cabinet.

In the test trolley of the present invention, the design of the control unit 30 is crucial for realizing automated testing. The control unit 30 may be realized in various ways, for example using a programmable logic controller (PLC). The PLC serves as the control unit 30, and the programming of the PLC can be customized according to test requirements, so as to realize an automated testing procedure, including but not limited to on/off switching of current, voltage adjustment, data acquisition and analysis, etc.

Compared with a conventional, manually operated switch cabinet test trolley, the test trolley of the present invention has many advantages. Firstly, as a result of integrating DC and AC power supply modules, the test trolley is able to supply various required electrical signals to the switch cabinet, including constant direct current/voltage, and single-phase or multi-phase alternating current/voltage. This integrated design reduces dependence on external power supplies, while also making testing more convenient and reliable. Secondly, the automated control unit of the test trolley can intelligently manage testing procedures of multiple switch cabinets, including on/off switching of switches, measurement of current and voltage, and data acquisition and analysis. This not only reduces the workload of on-site service personnel, but also reduces errors and risk caused by improper human operation. In addition, the test trolley of the present invention is also highly flexible and adaptable, being able to adapt to testing requirements and system configurations of different switch cabinets, while the modular design thereof allows rapid switching between different test functions, thus reducing the time taken to prepare and switch between different tools during testing. Finally, the intelligent and automated characteristics of the test trolley of the present invention enable it to conveniently perform storage and analysis of historical data and predict trends, thus providing effective data support for switch cabinet maintenance and management.

Another exemplary embodiment of the present invention further proposes an automatic testing system for a switch cabinet. The core component part of the system is the test trolley of the present invention; as described above with reference to Figs. 1 - 5, the test trolley comprises key components such as a DC power supply module, an AC power supply module, a control unit and a measurement circuit, and is able to automatically perform various electrical performance tests on the switch cabinet. For example, the test trolley may comprise a DC voltage module, for testing primary and secondary insulation resistances in the switch cabinet. In addition, the test trolley may also comprise an AC voltage tolerance module, mainly used for measuring mains frequency and surge voltage tolerance of a switch cabinet body.

Fig. 6 shows a block diagram of a switch cabinet automatic testing system according to an exemplary embodiment of the present invention. As shown in Fig. 6, the test trolley may have the circuit structure described above with reference to Figs. 2 - 5, e.g. may comprise modules such as a power supply device, a switching device, a control unit and a measurement device; the power supply device may in particular comprise the DC power supply device shown in Fig. 2 and the AC power supply device shown in Fig. 5. With this circuit structure, the test trolley can supply various test electrical signals to the switch cabinet, in order to realize corresponding test functions. For example, the test trolley can supply direct current to the switch cabinet, to measure various circuit resistances in the switch cabinet, and can also supply alternating current, to perform CT primary through-flow testing and temperature sensor function testing, etc.

In addition to supplying direct/alternating current, the test trolley can also supply DC voltage to the switch cabinet, to perform primary insulation testing (e.g. 2500 VDC/1 s or 2000 VDC/1 min) and secondary insulating testing (e.g. 1000 VDC). By suppling DC voltage, a test of lightning arrester leakage current can also be performed by measuring lightning arrester circuit resistance current. In addition, the test trolley can also supply AC voltage to the switch cabinet, in order to perform mains frequency voltage tolerance (unidirectional and bidirectional voltage tolerance) testing and frequency multiplication/surge voltage tolerance (unidirectional and bidirectional voltage tolerance) testing.

In addition to the test trolley, to ensure that the test trolley can be connected to the switch cabinet smoothly, the system further comprises a mechanical unlocking device. This device is specially designed to release a mechanical locking mechanism of the switch cabinet, for example to release mechanical quintuple-prevention interlocking of the switch cabinet, in order to ensure that the switch cabinet is in a testable state mechanically. In particular, the mechanical unlocking device can release mechanical locking between a circuit breaker and a grounding switch in the switch cabinet, to ensure that with the circuit breaker in a closed state in a working position, the grounding switch (or another form of electrical connection) can also be closed, so that the three phase power supply circuits A, B, C are connected at one end to the neutral point at the same time, thereby forming a test circuit between the test trolley and the switch cabinet.

In addition, the system may further comprise a main control device, which is the brain of the automatic testing system, responsible for overall control of the switch cabinet testing procedure. Once the mechanical unlocking device has successfully released the mechanical locking of the switch cabinet, the main control device will detect this change of state, and send an enable signal to the test trolley via a communication interface, to serve as a key instruction for activating the test trolley to begin the testing procedure. **In** addition to the enable signal, the main control device can also simultaneously send batch program commands to the test trolley. After receiving the enable signal, the test trolley begins to operate according to a preset testing procedure in the batch program commands. Through the cooperation of the mechanical unlocking device and the main control device, the test trolley is able to automatically perform the switch cabinet testing procedure while ensuring safety, thus further reducing the complexity and risk of on-site operations.

In particular, the automatic testing system can automatically perform three-phase overcurrent protection testing, zero sequence overcurrent protection testing, voltage protection testing, frequency protection testing and differential protection, etc. in sequence, using existing wiring to realize automatic testing, avoiding manual connection and disconnection of wires, and thus significantly improving the efficiency of testing of current transformers and relay protection devices, for example. Such an automated testing procedure not only reduces errors in human operation, but also greatly increases testing accuracy and reliability. The cooperation of the main control device, the test trolley and the unlocking mechanism makes the entire switch cabinet testing process smoother and more efficient, thereby ensuring uniformity and accuracy of test results.

In addition, the automatic testing system has significant advantages in terms of protection function testing. In a conventional manual testing scheme, test current and voltage are fed to relay protection terminals directly by means of an external power supply, to perform multiple protection tests on relay protection devices. This method is operationally complex, and wires need to be connected and disconnected manually to test each relay protection device, so efficiency is low. In comparison, the testing system of the present invention can introduce current into a primary main circuit by means of the test trolley, and input current to relay protection terminals after conversion by the transformation ratio of a current transformer, while a voltage circuit supplies power directly to relay protection device terminals by means of a power supply small busbar. These improvements not only simplify the operating procedure, but also increase the degree of automation of the testing procedure.

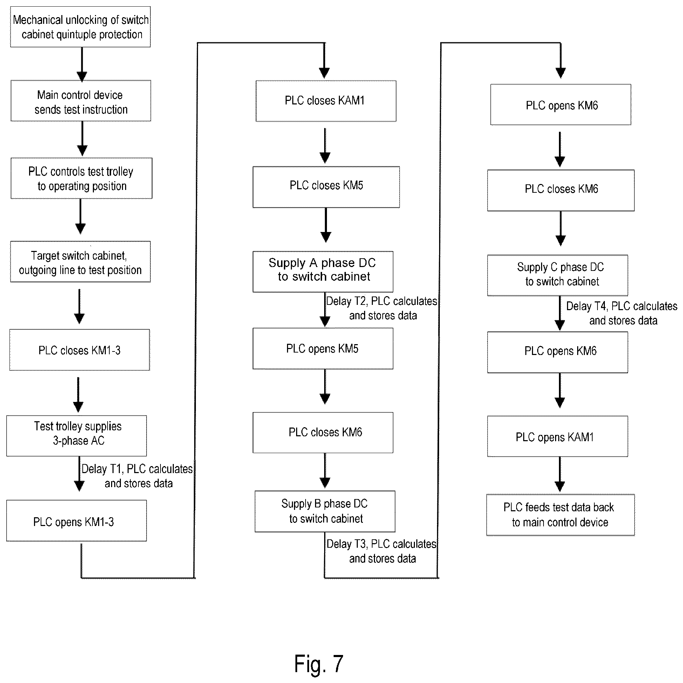

Fig. 7 shows a flow chart of operations of the switch cabinet automatic testing system in Fig. 6. Firstly, the mechanical unlocking device is used to release the quintuple-prevention interlocking of the target switch cabinet; once this has been released successfully, the main control device can send test instructions to the test trolley; upon receiving the test instructions, the PLC of the test trolley can control the test trolley to enter an operating position, while an outgoing line of the target switch cabinet enters a test position.

Once all test preparation procedures are complete, the PLC may for example firstly close KM1-3 in the AC power supply device, so as to supply three-phase AC to the switch cabinet; the PLC can then subject the switch cabinet to a corresponding AC testing procedure, including measurement of temperature sensor data, measurement of zero sequence current and current transformer testing, and verification of various protection functions for relay protection, such as voltage protection, overcurrent protection, overvoltage protection, low-voltage protection, differential protection, overheating protection, frequency protection, etc. The PLC can store corresponding test result data; after a delay of T1, the PLC can open KM1-3, in order to then perform a DC supply and testing procedure.

In the DC supply and testing procedure, the PLC can firstly close a main switch KAM1 of the DC power supply, then sequentially close switches KM5, KM6 and KM7 which correspond to phases A, B and C, and synchronously perform operations such as circuit current and voltage measurement and circuit resistance calculation; after completing power supply circuit resistance testing for all three phases of the switch cabinet, the PLC can open the main switch KAM1 of the DC power supply, thus completing the switch cabinet testing procedure, and the PLC reports test result data to the main control device. Based on this operating procedure, the automatic testing system realizes automated testing of the switch cabinet, greatly increasing testing efficiency, reducing the complexity and risk of manual operations, and ensuring that test results are accurate and reliable.

Another exemplary embodiment of the present invention further proposes a testing assembly for a medium-voltage power distribution cabinet, the medium-voltage power distribution cabinet comprising multiple switch cabinets, a ground bar, and a busbar formed of multiple phase buses; multiple phase power supply circuits are provided in each switch cabinet, each of the multiple phase power supply circuits having one end connected via a corresponding circuit breaker to a corresponding phase bus in the busbar, and another end connected via a corresponding grounding switch to the ground bar, and a distinctive feature of the testing assembly is that it further comprises the automatic testing system of the present invention.

When a particular switch cabinet is subjected to a testing procedure, the main control device can cause the switch cabinet to enter a test position and the test trolley to enter a working position, so as to form a test circuit between the switch cabinet and the test trolley. When the testing procedure is started, DC or AC supplied by the test trolley can reach a corresponding power supply circuit in the switch cabinet via the testing circuit, in order to complete the necessary performance test task. Upon completion of the testing procedure for a corresponding switch cabinet, the control unit 30 in the test trolley can send an instruction signal to the main control device; upon receiving the instruction signal from the test trolley, the main control device can cause the switch cabinet currently being tested to exit the test position, and cause the next switch cabinet to enter the test position, until the testing procedures for all of the switch cabinets are completed.

The switch cabinet testing procedure involves different switch position states, in particular the abovementioned "test position" and a "cold standby position": in the test position, the circuit breaker of each phase power supply circuit in the switch cabinet is closed, and the grounding switch is also closed; in the cold standby position, the circuit breaker of each phase power supply circuit in the switch cabinet is open, and the grounding switch is closed. Conventional testing schemes are unable to realize this switch state combination in the test position, whereas the testing assembly of the present invention is able to realize the closing of the grounding switch and the circuit breakers in the test position safely; this assists more comprehensive assessment of the overall performance of the power distribution cabinet.

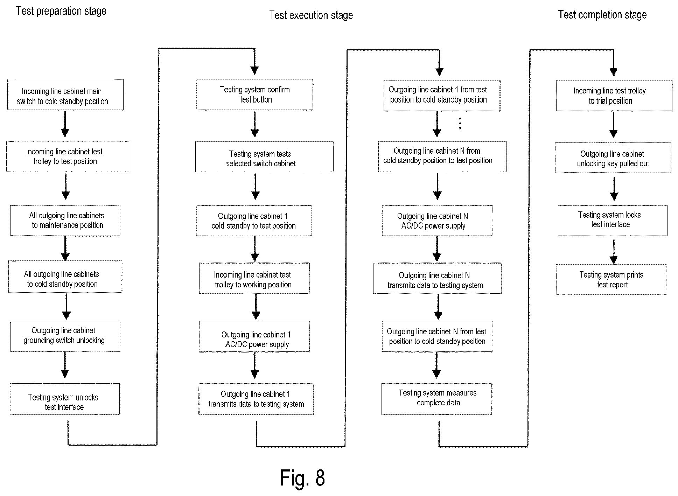

Fig. 8 shows a flow chart of operations for using an automatic testing system according to an exemplary embodiment of the present invention to subject all switch cabinets in a medium-voltage power distribution cabinet to a testing procedure. The testing procedure essentially comprises three stages, specifically test preparation, test execution and test completion. The switch cabinet (incoming line cabinet or outgoing line cabinet) involved in the three test stages mainly includes the following three position states:

- maintenance position: main switch open, in a trial position, grounding switch closed;

- cold standby position: main switch open, in the trial position, grounding switch open;

- test position: main switch closed, in the working position, grounding switch closed.

In the description of different position states above, the main switch represents a set of principal switching devices in the switch cabinet, including a circuit breaker, an isolating switch, etc. The test position is a key position that can be realized by means of the automatic testing system of the present invention; in the test position, the main switch (especially the circuit breaker of the switch cabinet) is closed, in the working position, and the grounding switch is closed. Conventional testing schemes are unable to realize this switch state combination in the test position.

As shown in Fig. 8, throughout the process of testing the medium-voltage power distribution cabinet, with the aid of the different position combinations of the switch cabinet mentioned above, and by means of the main control device, a power supply trolley and a mechanical unlocking mechanism, etc. in the automatic testing system, automatic switching and data test work for all switch positions is completed automatically in sequence, and a complete test report is generated. The automatic testing process significantly reduces the requirement for manual operation, reducing the possibility of human error and increasing test efficiency.

Correspondingly, the process of testing the switch cabinet also involves a set of strict unlocking and management procedures for the key box, so as to ensure the safety and accuracy of testing operations to the maximum extent. The key box may be integrated in the test trolley, and is used for managing grounding switch keys of a physical protection mechanism for unlocking switch cabinets. The management procedure of the key box comprises:

Firstly, in the automatic testing system, the operator needs to set the incoming line cabinet and a busbar connection cabinet to a cold standby position by means of a one-button sequential control function; this step is a preparation step before testing, and ensures that the switch cabinet is in a safe state.

Next, the operator inserts a switch key into a test selection switch of the incoming line cabinet, and moves the switch from a test exit state to a test entry state; at this time, closing of the circuit breaker of the incoming line cabinet is locked.

Next, the key in the test selection switch is pulled out, and inserted in a grounding switch unlocking key box; the key box is opened, and a grounding switch unlocking key is taken out. Once any unlocking key has been taken out, a key box door will be unable to close, and the switch key will be unable to be pulled out; this ensures continuity and safety of operation.

After completing the relevant testing, the operator needs to pull out all of the grounding switch unlocking keys. Next, the unlocking keys are put into the key box again; only after ensuring that all of the unlocking keys have been returned to their positions, can the key box door be closed and the switch key be pulled out. This step ensures safe recovery of equipment when testing has ended.

Finally, the operator re-inserts the switch key into the test selection switch of the incoming line cabinet, and moves the switch from the test entry state to the test exit state, releasing the locking of closing of the circuit breaker of the incoming line cabinet. When these steps have been completed, the switch key is pulled out and properly stored, ensuring the safety of equipment in the non-testing state.

The key box management process described above is crucial for ensuring the safety and accuracy of switch cabinet testing. Through this procedure, the operator is able to perform operations according to a strict sequence and strict specifications, thereby avoiding accidents or erroneous operations during testing. The entire process not only makes the operations more standardized and reliable, but also effectively prevents damage to equipment or safety incidents due to errors in operation, significantly increasing the safety and efficiency of the entire testing system.

Those skilled in the art will understand that the various steps of the method according to the present invention are not limited to being performed in the sequence listed above. **In** addition, in the present invention, words such as "including" and "comprising" mean that besides having the steps that are directly and explicitly expressed in the description and claims, the technical solution of the present application does not exclude the case where there are other steps not directly or explicitly expressed.

Although the present invention has been disclosed above with preferred embodiments, the present invention is not limited to this. Various changes and amendments made by any person skilled in the art without departing from the spirit and scope of the present invention shall be included in the scope of protection thereof. Therefore, the scope of protection of the present invention shall be the scope defined in the claims.

**Claims**

1. Test trolley for a switch cabinet, wherein multiple test points and multiple phase power supply circuits are provided in the switch cabinet, each phase power supply circuit having one end connected to a corresponding one of the multiple test points, and another end connected to a neutral point, and when the switch cabinet enters a testing procedure, the test trolley is electrically connected to the multiple test points of the switch cabinet, **characterized in that** the test trolley comprises:

a power supply device, for supplying a test electrical signal to the switch cabinet when the switch cabinet enters a testing procedure;
a switching device, comprising multiple switches (KM1 - KM10), each switch being used to connect the power supply device to a corresponding one of the multiple test points or to the neutral point;
a control unit (30), configured to selectively control the on/off switching of the switches in the switching device, so as to supply AC or DC to at least one of the multiple phase power supply circuits by means of the power supply device; and
a measurement device, configured to selectively measure a current value and/or a voltage value on at least one of the multiple phase power supply circuits under the control of the control unit (30), and feed a measurement result back to the control unit (30),
wherein the control unit (30) is further configured to determine electrical performance of the switch cabinet on the basis of the measurement result provided by the measurement device.

2. Test trolley according to Claim 1, **characterized in that** the power supply device comprises a DC power supply device (10), for supplying constant DC to at least one of the multiple phase power supply circuits when the switch cabinet enters the testing procedure;

the switching device comprises a first switching assembly consisting of multiple switches (KM5, KM6, KM7, KM8, KM9, KM10), each switch in the first switching assembly having a first end connected to a positive pole or a negative pole of the DC power supply device, and a second end connected to a corresponding one of the multiple test points or to the neutral point, wherein the control unit (30) is configured to selectively close two corresponding switches in the first switching assembly, so that DC outputted by the DC power supply device flows through at least one of the multiple phase power supply circuits, the measurement device comprises a DC measurement circuit (40), and the control unit (30) is further configured to control the DC measurement circuit (40) to selectively measure voltage values at multiple target sampling points on a current circulation path located between the DC power supply device (10) and the switch cabinet, so as to determine electrical performance of the switch cabinet on the basis of the voltage values at the multiple target sampling points.

3. Test trolley according to Claim 2, **characterized in that** the DC measurement circuit (40) comprises a current divider (RS), a second switching assembly (401) and a signal acquisition board (402), the current divider being connected in series between the positive pole or negative pole of the DC power supply device and a first end of the first switching assembly (20), the second switching assembly (401) consisting of multiple contactors (KA8, KA9, KA10, KA11, KA12, KA13), each contactor having one end connected to a corresponding one of the multiple test points or to the negative pole of the DC power supply device (10), and another end connected to the signal acquisition board, wherein the control unit (30) is further configured to:

- control the DC measurement circuit (40) to acquire a voltage drop across the current divider, so as to calculate an output current of the DC power supply device on the basis of the voltage drop;
- selectively close two corresponding contactors in the second switching assembly, so as to control the signal acquisition board to acquire a voltage difference between a corresponding one of the multiple test points and the negative pole of the DC power supply device (10), or acquire a voltage difference between two corresponding test points of the multiple test points; and
- calculate a circuit resistance of each phase power supply circuit in the switch cabinet on the basis of the voltage difference acquired by the signal acquisition board and the output current of the DC power supply device.

4. Test trolley according to Claim 2 or 3, **characterized in that** the first switching assembly (20) comprises:

multiple first switches (KM5, KM6, KM7), each first switch being arranged between the positive pole of the DC power supply device (10) and one corresponding test point in the switch cabinet; multiple second switches (KM9, KM10), each second switch being arranged between one corresponding test point in the switch cabinet and the negative pole of the DC power supply device (10); and a third switch (KM8), arranged between the negative pole of the DC power supply device (10) and the neutral point of the switch cabinet, wherein the control unit (30) is further configured to:

- selectively close the third switch (KM8) and at least one of the multiple first switches (KM5, KM6, KM7), so that DC supplied by the DC power supply device flows through at least one phase power supply circuit, connected in parallel with each other, of the multiple phase power supply circuits; or
- selectively close a corresponding one of the multiple first switches (KM5, KM6, KM7) and a corresponding one of the multiple second switches (KM9, KM10), so that DC supplied by the DC power supply device flows through two phase power supply circuits, connected in series with each other, of the multiple phase power supply circuits.

5. Test trolley according to Claim 3, **characterized in that** the signal acquisition board (402) comprises two voltage sampling ports, and the second switching assembly (401) comprises:

multiple first contactors, each first contactor being arranged between one corresponding test point in the switch cabinet and a first voltage sampling port of the signal acquisition board; multiple second contactors, each second contactor being arranged between one corresponding test point in the switch cabinet and a second voltage sampling port of the signal acquisition board; and

a third contactor, arranged between the first voltage sampling port of the signal acquisition board and the negative pole of the DC power supply device (10),

wherein the control unit (30) is configured to determine the on/off switching of each contactor in the second switching assembly (401) on the basis of a switch state of each switch in the first switching assembly, in order to acquire a voltage difference between two respectively connected test points of the multiple test points, or a voltage difference between at least one connected test point and the negative pole of the DC power supply device (10), by means of the signal acquisition board.

6. Test trolley according to Claim 4, **characterized in that** the control unit (30) is further configured to:

   close the third switch (KM8), and open the multiple second switches (KM9, KM10);
   sequentially close each of the multiple first switches (KM5, KM6, KM7) to connect the corresponding test point, and determine multiple first resistance values ($R_1,R_2,R_3$) between the connected test point and the negative pole of the DC power supply device (10) by means of the DC measurement circuit (40);
   close any two of the multiple first switches (KM5, KM6, KM7) so that any two of the multiple phase power supply circuits form a parallel-connected circuit, and determine a second resistance value ($R_4$) between the connected test point and the negative pole of the DC power supply device (10) by means of the DC measurement circuit (40); and
   based on the multiple first resistance values ($R_1$, $R_2,R_3$) and the second resistance value ($R_4$), calculate circuit resistances ($R_a,R_b,R_c$) of the phase power supply circuits in the switch cabinet.

7. Test trolley according to Claim 5 and 6, **characterized in that** the control unit (30) is further configured to close the third contactor and a corresponding one of the multiple second contactors when determining the multiple first resistance values ($R_1,R_2,R_3$), and close the third contactor and two corresponding second contactors of the multiple second contactors when determining the second resistance value ($R_4$).

8. Test trolley according to Claim 4, 6 or 7, **characterized in that** the control unit (30) is further configured to:

   open the third switch (KM8);
   close a corresponding one of the multiple first switches (KM5, KM6, KM7) and a corresponding one of the multiple second switches (KM9, KM10), so that any two of the multiple phase power supply circuits form multiple different series-connected circuits, and respectively determine third resistance values ($R_{ab},R_{bc},R_{ca}$) of the multiple different series-connected circuits by means of the DC measurement circuit (40); and
   based on the third resistance values ($R_{ab},R_{bc}$, $R_{ca}$) of the multiple different series-connected circuits, calculate circuit resistances ($R_a,R_b,R_c$) of the phase power supply circuits in the switch cabinet.

9. Test trolley according to Claim 8, **characterized in that** the control unit (30) is further configured to close a corresponding one of the multiple first contactors and a corresponding one of the multiple second contactors when determining the third resistance values ($R_{ab},R_{bc}, R_{ca}$) of the multiple different series-connected circuits.

10. Test trolley according to any one of Claims 1 - 9, **characterized in that** the power supply device further comprises an AC power supply device, configured to supply at least one phase of AC to the switch cabinet when the switch cabinet enters the testing procedure.

11. Test trolley according to Claim 10, **characterized in that** the AC power supply device comprises:

   multiple power supply conversion modules, each power supply conversion module being configured to receive AC from an external power grid and subject same to a voltage and/or current adjustment operation, so as to output a required test current to a corresponding one of the multiple phase power supply circuits of the switch cabinet; and
   a third switching assembly (KM1, KM1, KM3, KM4), comprising a fourth switch (KM4) and multiple fifth switches (KM1, KM2, KM3), each fifth switch being used to connect a first output end of a corresponding one of the multiple power supply conversion modules to one corresponding test point in the switch cabinet, and the fourth switch being used to connect a second output end of the multiple power supply conversion modules to the neutral point of the switch cabinet,
   wherein the control unit (30) is further configured to selectively close the fourth switch (KM4) and at least one of the multiple fifth switches (KM1, KM2, KM3), so as to supply at least one phase of AC to the switch cabinet.

**12.** Test trolley according to Claim 10 or 11, **characterized in that** the measurement device further comprises multiple Hall sensors, each Hall sensor being arranged on an output line of a corresponding one of the multiple power supply conversion modules, and used to measure a current value of AC outputted by the AC power supply device to the switch cabinet.

**13.** Test trolley according to Claim 12, **characterized in that** the control unit (30) is further configured to subject the switch cabinet to performance testing on the basis of a measurement result of the multiple Hall sensors, the performance testing being selected from at least one of a group comprising overcurrent protection testing, zero sequence overcurrent protection testing, voltage protection testing, frequency protection testing, differential protection testing, current transformer data testing, temperature sensor data testing and zero sequence current testing.

**14.** Automatic testing system for a switch cabinet, **characterized in that** the system comprises:

the test trolley according to any one of Claims 1 - 13;
a mechanical unlocking device, for releasing mechanical locking between a circuit breaker of the switch cabinet and a grounding switch; and
a main control device, configured to send a corresponding enable signal to the test trolley after mechanical locking of the switch cabinet has been released, so that the test trolley begins to subject the switch cabinet to the testing procedure.

**15.** Testing assembly for a medium-voltage power distribution cabinet, the medium-voltage power distribution cabinet comprising multiple switch cabinets, a ground bar, and a busbar formed of multiple phase buses, wherein multiple phase power supply circuits are provided in each switch cabinet, each of the multiple phase power supply circuits having one end connected via a corresponding circuit breaker to one corresponding phase bus in the busbar, and another end connected via a corresponding grounding switch to the ground bar, **characterized in that** the testing assembly further comprises the automatic testing system according to Claim 14, wherein the main control device is further configured, when subjecting a corresponding one of the multiple switch cabinets to the testing procedure, to cause the corresponding one switch cabinet to enter a test position and cause the test trolley to enter a working position, so as to form a test circuit between the switch cabinet and the test trolley, the control unit (30) of the test trolley is further configured to send an instruction signal to the main control device upon completion of the testing procedure for the corresponding one switch cabinet, and the main control device is configured, upon receiving the instruction signal from the test trolley, to cause the corresponding one switch cabinet to exit the test position and cause the next switch cabinet to enter the test position, until the testing procedures for all of the switch cabinets are completed, wherein, in the test position, the grounding switch and the circuit breaker of each phase power supply circuit in the corresponding one switch cabinet are closed.

Fig. 1

Fig. 2

Single-phase circuit resistance test

incoming line cabinet     switch cabinet 1     switch cabinet N

Fig. 3

Inter-phase circuit resistance test

incoming line cabinet     incoming line cabinet 1     incoming line cabinet N

Fig. 4

Fig. 5

Fig. 6

Mechanical unlocking of switch cabinet quintuple protection

↓

Main control device sends test instruction

↓

PLC controls test trolley to operating position

↓

Target switch cabinet, outgoing line to test position

↓

PLC closes KM1-3

↓

Test trolley supplies 3-phase AC

Delay T1, PLC calculates and stores data
↓

PLC opens KM1-3

PLC closes KAM1

↓

PLC closes KM5

↓

Supply A phase DC to switch cabinet

Delay T2, PLC calculates and stores data
↓

PLC opens KM5

↓

PLC closes KM6

↓

Supply B phase DC to switch cabinet

Delay T3, PLC calculates and stores data

PLC opens KM6

↓

PLC closes KM6

↓

Supply C phase DC to switch cabinet

Delay T4, PLC calculates and stores data
↓

PLC opens KM6

↓

PLC opens KAM1

↓

PLC feeds test data back to main control device

Fig. 7

EP 4 686 953 A1

Test preparation stage
Test execution stage
Test completion stage

Fig. 8

22

Europäisches
Patentamt
European
Patent Office
Office européen
des brevets

# EUROPEAN SEARCH REPORT

**Application Number**

EP 25 19 1938

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 218 647 107 U (GUANGDONG FULLDE ELECTRONICS CO LTD ET AL.) 17 March 2023 (2023-03-17) | 1,2,10, 12-15 | INV. G01R31/327 |
| A | * abstract * * figure 1 * * paragraphs [0004] - [0019] * * claims 1,3-5 * ----- | 3-9,11 | |
| A | CN 113 933 566 A (INNOVATION ACADEMY FOR MICROSATELLITES OF CAS ET AL.) 14 January 2022 (2022-01-14) * abstract * * figures 1-2 * * paragraphs [0063] - [0105] * ----- | 1-15 | |

**TECHNICAL FIELDS SEARCHED (IPC)**

G01R

The present search report has been drawn up for all claims

| Place of search | Date of completion of the search | Examiner |
|---|---|---|
| The Hague | 17 December 2025 | Mouanda, Thierry |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
........................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 19 1938

This annex lists the patent family members relating to the patent documents cited in the above-mentioned European search report.
The members are as contained in the European Patent Office EDP file on
The European Patent Office is in no way liable for these particulars which are merely given for the purpose of information.

17-12-2025

| Patent document cited in search report | | Publication date | Patent family member(s) | | Publication date |
|---|---|---|---|---|---|
| CN 218647107 | U | 17-03-2023 | NONE | | |
| CN 113933566 | A | 14-01-2022 | CN | 112834965 A | 25-05-2021 |
| | | | CN | 113933566 A | 14-01-2022 |

For more details about this annex : see Official Journal of the European Patent Office, No. 12/82